# EUROPEAN PATENT SPECIFICATION

(11) **EP 1 389 833 B1**
(45) Date of publication and mention of the grant of the patent: **21.05.2014**
(21) Application number: 03018305.7
(22) Date of filing: 12.08.2003
(51) Int. Cl.: H03K 19/003

(54) **Method and circuit for reducing hot-carrier injection stress**
Verfahren und Schaltungsanordnung zur Verminderung der Effekte der Injektion von hochenergetischen Ladungsträgern
Procédé et circuit pour la réduction de la tension due à l'injection de porteurs de charge chaude

(30) Priority: 12.08.2002 US 402770 P; 01.07.2003 US 611585
(43) Date of publication of application: 18.02.2004
(73) Proprietor: Broadcom Corporation, Irvine, CA 92617 (US)
(72) Inventor: Oertle, Kent, 85044 Phoenix (US); Elio, Robert F., 85213 Mesa, Arizona (US); McFarland, Duncan, 85284 Tempe (US); Benzer, Darrin, 85226 Chandler, Arizona (US)
(74) Representative: Jehle, Volker Armin

(56) References cited:
- EP-A- 0 862 267
- US-A- 5 721 508
- US-A- 6 018 257
- US-A- 6 081 412
- US-A- 6 130 556

## Description

### BACKGROUND OF THE INVENTION

The present invention relates to a circuit and method for reducing stress on an output device. More specifically, the present invention relates to an HCI stress circuit and method using low voltage devices adapted to limit voltage across an output device, thereby reducing HCI stress.

In modern CMOS ASIC designs, the core circuitry generally operates at a lower voltage than the 10 circuits. This provides a core circuitry design that operates at higher speeds with lower power consumption. However, since the maximum operating voltage of such current CMOS ASIC core circuitry designs is also lower, these devices may not be used directly with currently known 10 circuits without special design considerations. In particular, stress on the 10 circuits must be taken into consideration when designing CMOS ASIC circuits.

US 6,130,556 A discloses an integrated circuit buffer including a core output terminal, a pad terminal, a pad pull-down transistor, a pad pull-up transistor, a pull-down control circuit and a pull-up control circuit. The pad pull-down transistor and the pad pull-up transistor are coupled to the pad terminal and have pull-up and pull-down control terminals, respectively.

US 6,081,412 A discloses that an output driver prevents gate oxide breakdown and reverse charge leakage from a bus to the internal power supply. When the voltage on the bus exceeds the internal supply voltage or when the driver is powered down, a reference voltage generator provides intermediate voltages to prevent the development of excessive gate-source, gate-drain, and gate-backgate voltages in the driver.

EP 0 862 267 A2 discloses an integrated circuit having an I/O circuit that is connected to an I/O PAD. The I/O PAD may have greater voltage than the VDD associated with the integrated circuit so there is provided a switching circuit that is connected between the VDD and the I/O PAD.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

The invention is defined in the appended claims.

Features of the present invention may be found in a design method and circuit enabling IO devices in a CMOS ASIC design to utilize more efficient transistors while not subjecting such devices to stress.

More specifically, one example relates to a circuit coupled to an output device, where the circuit comprises at least one transistor device adapted to limit a duration of a high voltage across the output device, thereby reducing hot carrier injection stress. The circuit comprises a p-channel transistor or device coupled to the output device, while in another example the circuit comprises two stacked transistor devices (stacked p-channel transistors or devices for example) coupled to the output device (an n-channel output transistor or device for example).

The integrated circuit comprises an IO PAD, an output circuit coupled to at least the IO PAD and a stress circuit. The stress circuit is coupled to at least the output circuit and is adapted to limit a duration of a high voltage across the output circuit when the output circuit is enabled, and the PAD voltage is greater than VDDO thereby reducing stress on the output circuit.

Yet another example relates to a method of reducing stress across an output circuit. In this example, the method comprises determining if the output circuit is tri-stated and determining if a PAD voltage is greater than a predetermined voltage level. The method further comprises enabling the output circuit, turning on a stress circuit that dissipates voltage across the output circuit while the output circuit transitions to a low state, thereby preventing the output circuit form experiencing HCl stress.

These and other advantages and novel features of the present invention, as well as details of an illustrated embodiment thereof, will be more fully understood from the following description and drawings.

### BRIEF DESCRIPTION OF SEVERAL VIEWS OF THE DRAWINGS

Fig. 1 illustrates one example of a circuit diagram of a portion of an integrated circuit having an output circuit coupled to an IO PAD;
Fig. 2 illustrates a block diagram of one embodiment of an integrated circuit in accordance with the present invention;
Fig. 3 illustrates a block diagram of another embodiment of an integrated circuit similar to that illustrated in Fig. 2 in accordance with the present invention;
Fig. 4 illustrates a circuit diagram of an HCI stress circuit in accordance with the present invention; and
Fig. 5 illustrates a high level flow chart of one method of limiting a high voltage across an output circuit, thereby reducing or eliminating stress in accordance with the present invention.

### DETAILED DESCRIPTION OF THE INVENTION

The following description is made with reference to the appended figures.

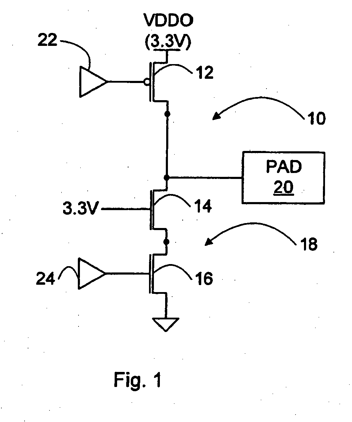

Fig. 1 illustrates one example of integrated circuit, generally designated 10, comprising three transistor devices, one PMOS device 12 and two NMOS devices 14 and 16. In this example, devices 14 and 16 form an output device or circuit, generally designated 18. IO PAD 20 is shown coupled to at least device 12 and output device 18. It is contemplated that the IO PAD 20 is coupled to, and driven by, external circuitry via a bus (not shown) when integrated circuit 10 is tri-stated or turned off. Two pre-driver devices 22 and 24 are illustrated, coupled to PMOS device 12 and NMOS device 16 respectively. It is contemplated that, in this embodiment, device 12 is a floating well transistor device.

Tri-stating the circuit 10 means that the output device 18 and the device 12 are tri-stated (i.e., turned off). When output device 18 and device 12 are tri-stated or turned off, the bus takes over, driving the IO PAD 20 and output device 18 to the high voltage (5.5V for example). In the illustrated example, when the circuit 10 is enabled; devices 14 and 16 turn on, pulling IO PAD 20 from the high voltage to ground, placing a great amount of stress more specifically hot carrier injection (alternatively referred to as "HCI") stress on devices 14 and 16. It is desirable to limit the amount of time the high voltage appears across the output device 18.

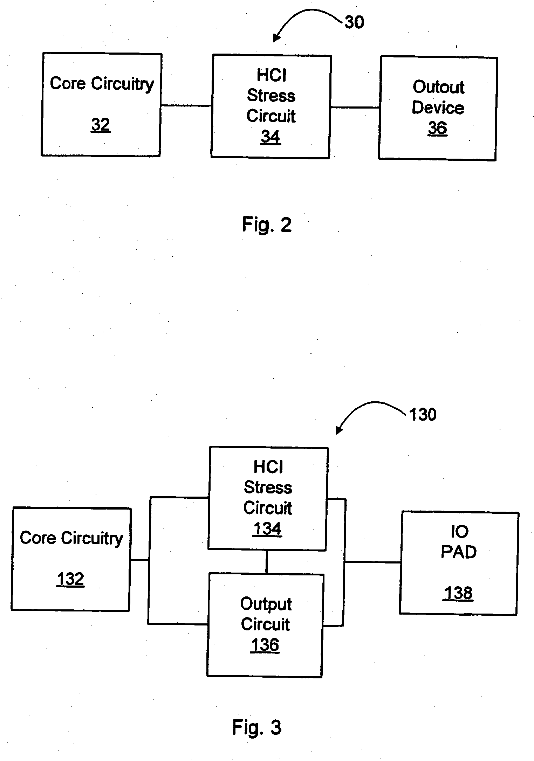

Fig. 2 illustrates a block diagram of one embodiment of an integrated circuit, generally designated 30, in accordance with the present invention. In the illustrated embodiment, the integrated circuit 30 comprises at least core circuitry 32 and output device 36 which is adapted to be coupled to, and driven by, external circuitry via a bus (not shown).

In CMOS design, the core circuitry 32 generally operates at a lower voltage than the PAD voltage. For example, a high voltage (about 5.5V) may be applied to the output device 36, but a lower voltage (about 2.5V for example) is applied across the junctions in the core circuitry 32.

In this embodiment, a HCI stress circuit, generally designated 34, is illustrated coupled to both the core circuitry 32 and the output device 36. The stress circuit 34 is adapted to limit the amount of time the high voltage appears across the output device 36, thereby reducing or eliminating HCI stress.

Fig. 3 illustrates a block diagram of another embodiment of an integrated circuit, generally designated 130, in accordance with the present invention. In the illustrated embodiment, the integrated circuit 130 comprises at least core circuitry 132, output circuit or device 136 and IO PAD 138 which is adapted to be coupled to, and driven by, external circuitry via a bus (not shown).

Again, the core circuitry 132 generally operates at a lower voltage than the PAD voltage. In this embodiment, an HCI stress circuit, generally designated 134, is illustrated coupled to the core circuitry 132, the output device or circuit 136 and the IO PAD 138. The stress circuit 134 is adapted to limit the amount of time the high voltage appears across the output device 136 when the output device 136 is enabled, thereby reducing or eliminating HCI stress.

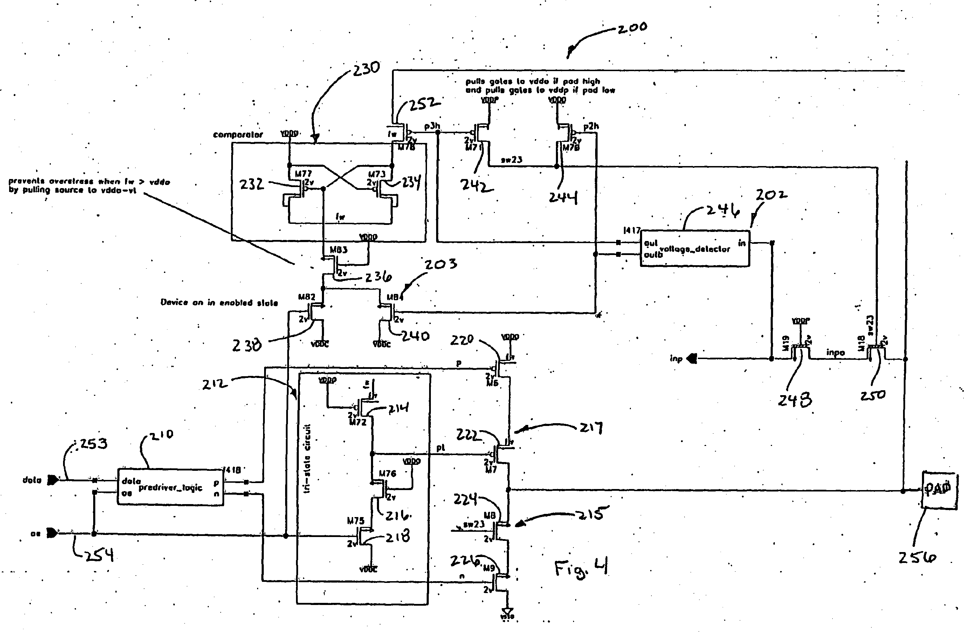

One embodiment of an integrated circuit, generally designated 200, is illustrated in Fig. 4. In accordance with the present invention, this embodiment comprises at least a voltage detect circuit, generally designated 202, adapted to detect when a voltage is sufficient to switch bias conditions without violating the maximum transistor operating conditions for the process; a comparator or comparator circuit, generally designated 230, adapted to determine when the PAD voltage is greater than the IO power supply voltage; a tri-state circuit 212 adapted to ensure one or more device(s) coupled to at least the 10 PAD 256 will not turn on, and circuits 215 and 217 will not be overstressed when the PAD voltage exceeds the 10 power supply voltage; output device or circuit 215; and an HCI stress device or circuit 217, adapted to limit the amount of time a high voltage appears across the output device 215 when IO PAD 256 transitions from a tri-state voltage to V_{PAD} = GND.

In accordance with one embodiment, an overstress circuit, generally designated 203, prevents overstress of the circuit 200 when the floating well (alternatively referred to as "fw") is greater than VDDO, by turning off and allowing a source of at least one device to pull up to VDDO - Vₜ. In this embodiment, the overstress circuit 203 comprises at least one, but generally three, transistor devices, such as three NMOS or n-channel transistor devices 236, 238 and 240 for example.

In the illustrated embodiment, the voltage detect circuit 202 is adapted to detect when a voltage is sufficient to switch the bias conditions without violating maximum transistor operating conditions for the process. In the circuit 200 illustrated in Fig. 4, the voltage detect circuit comprises a voltage detect device 246 having an input coupled to device 248 and node inp, a node out output coupled to node p3h, and PMOS devices 242 and 252, and a node outb coupled to NMOS device 240 and PMOS device 244. In this embodiment, it is contemplated that the voltage detect device 246 is adapted to determine whether the PAD voltage is high or low (i.e., the in signal and out signal of the detect device 246 are the same and the outb signal is the opposite of the out signal).

The integrated circuit 200 also comprises the comparator circuit 230 adapted to determine when the PAD voltage is greater than the IO power supply voltage. In this embodiment, the comparator 230 comprises at least one, but generally two or more devices, such as two PMOS or p-channel transistor devices 232 and 234 for example.

This embodiment further comprises tri-state circuit 212 adapted to guarantee that a device, such as a PMOS or p-channel transistor device 222 for example, will not turn on when the PAD voltage exceeds the IO power supply voltage. In this embodiment, the tri-state circuit 212 comprises at least one, but generally three, devices, such as a PMOS or p-channel transistor device 214 and two NMOS or n-channel transistor devices 216 and 218.

In the embodiment illustrated in Fig. 4 an output device or circuit 215 is illustrated coupled to or communicating with at least pre-driver logic device 210 and IO PAD 256. In the illustrated embodiment, the output device 215 comprises at least one but generally two devices. Here, the output device 215 comprises two stacked n-channel or NMOS devices 224 and 226, although other devices are contemplated.

Fig. 4 further illustrates an HCI stress device or circuit 217, adapted to limit the high voltage across output device or circuit 215 when the 10 PAD 256 is transitioning from a tri-state voltage, V_{PAD} > VDDO, to an enabled state of V_{PAD} = GND, reducing stress thereon. In this embodiment, the stress device or circuit 217 comprises at least one but generally two devices. Here, the stress device 217 comprises two stacked p-channel or PMOS devices 220 and 222, although other devices are contemplated.

One embodiment of the present invention comprises at least one, but generally two or more power supplies. In the illustrated embodiment, three power supplies are contemplated; the core power supply or VDDC, the intermediate power supply, or VDDP, and the IO power supply or VDDO. VDDP is set to the maximum IO device voltage (i.e., less than VDDO for example). It is contemplated that setting VDDP to the maximum IO device voltage limits the maximum voltage across any device, maintaining gate oxide reliability and avoiding hot carrier injection or HCI stress. In this illustrated embodiment, it is contemplated that the PAD voltage will not exceed a predetermined amount (two times for example) the maximum device voltage and VDDO-VDDC will not exceed the maximum device voltage.

The circuit 200 further comprises a node sw23, coupled to at least one but generally two or more devices, PMOS or p-channel transistor 242 and 244 for example. Nodes p3h and p2h and devices 242 and 244 are adapted to pull node sw23 to VDDO if the PAD voltage is high, and to VDDP if the PAD voltage is low. IO PAD 256 is illustrated coupled to at least sw23 and transistor device 250.

In accordance with one embodiment of the present invention where the PMOS driver is tri-stated, HCI stress may be significantly reduced when the output is enabled with the PAD at 5.5V. For example, if the PAD is at 5.5V and the output is enabled with the data low, a very large Vds voltage appears on devices 224 and 226 resulting in HCI stress on devices 224 and 226 as they are on. In accordance with the present invention, node pt pulls low and device 222 is turned on when the output is enabled. Since the PAD voltage is greater than VDDO, device 220 is also on, dissipating some of the charge through devices 222 and 220, limiting the amount of time the high voltage appears across the output device. Since s23 is at VDDO, device 224 is not stressed even when the PAD is at 5.5V.

The circuit 200 further comprises a pre-driver logic device 210, which is adapted to generate one or more logic states that drive the stacked output devices. The pre-driver logic device 210 is coupled to nodes data 253 and output enable node (alternatively referred to as "oe") 254, and the stacked output devices. In this embodiment, nodes data 253 and oe 254 are coupled to the core circuitry (not shown).

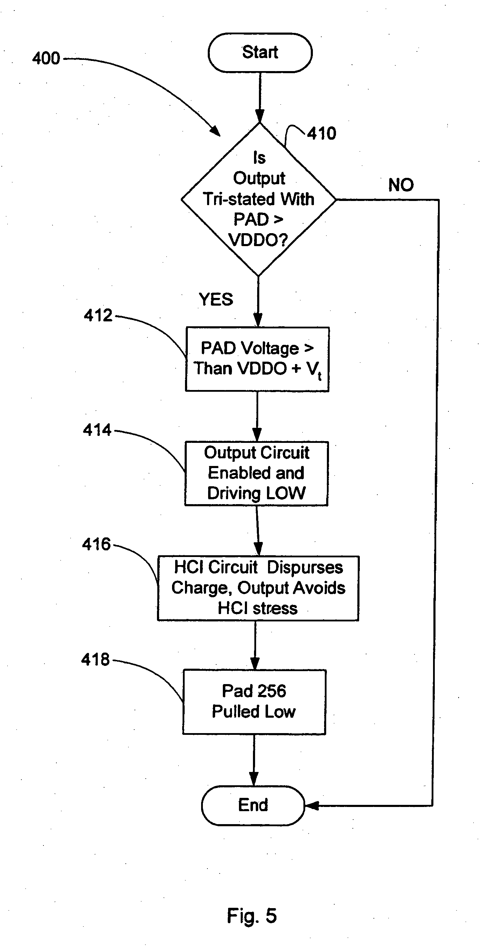

Fig. 5 illustrates one method of reducing HCI stress by limiting the duration of the high voltage across an output device when the output device is enabled. Fig. 5 illustrates one method of reducing HCI stress, generally designated 400, wherein the method determines if the output is tri-stated with PAD > VDDO as illustrated by diamond 410.

Block 412 illustrates when PAD > VDDO + Vₜ, where Vₜ is the threshold of the PMOS device. Block 414 illustrates when the output circuit is enabled and driving LOW. The HCI stress circuit turns on, dispersing or dissipating the charge across the output circuit so that the output circuit avoids HCI stress and pulls Pad 256 LOW as illustrated by blocks 416 and 418.

It is contemplated that the HCI stress circuit, and a method of reducing HCI stress in accordance with the present invention provides/includes one or more of the following advantages and features: (1) enables lower power and high speed design of core/analog circuits; (2) simplifies fabrication process and cost; and (3) reduces HCI stress on the NMOS output driver.

Many modifications and variations of the present invention are possible within the scope of the appended claims.

## Claims

1. An integrated circuit (200) comprising:
an IO PAD;
an output circuit coupled to at least said IO PAD;
a stress circuit (217) coupled to at least said output circuit and comprising at least one first p-channel transistor (222) with its well floating and defining a floating well node (fw);
means for determining if the output circuit is tri-stated;
means (230) for determining if a voltage applied to said IO PAD is greater than a first predetermined voltage level (VDDO+Vₜ) and comprising at least two second p-channel transistors (232, 234) with a threshold voltage (Vₜ) and their wells coupled to said floating well node (fw);
an overstress circuit (203) adapted to prevent overstress of the integrated circuit (200) when the voltage at the floating well node (fw) is greater than a second predetermined voltage level (VDDO) by pulling the gate terminal of one of the at least two second p-channel transistors (232, 234) to a third predetermined voltage level (VDDO-Vₜ) by at least one transistor device;
means for enabling the output circuit when the voltage applied to said IO PAD is greater than the first predetermined voltage level (VDDO+Vₜ); and
means for turning on the stress circuit (217) for dissipating a voltage across the output circuit, thereby limiting a duration of a high voltage across the output circuit.

2. The integrated circuit of Claim 1, wherein said stress circuit (217) comprises at least one further transistor.

3. The integrated circuit of Claim 2, wherein said transistor comprises at least one further p-channel transistor (220).

4. The integrated circuit of Claim 2, wherein said transistor comprises two stacked p-channel transistors (222, 220).

5. The integrated circuit of Claim 1, wherein said output circuit comprises at least one transistor.

6. The integrated circuit of Claim 5, wherein said transistor comprises an n-channel transistor (226).

7. The integrated circuit of Claim 5, wherein said transistor comprises two stacked n-channel transistors (226, 224).

8. A method of reducing stress across an output circuit of an integrated circuit (200), comprising:
an IO PAD;
wherein the output circuit is coupled to at least said IO PAD;
a stress circuit (217) coupled to at least said output circuit and comprising at least one first p-channel transistor (222) with its well floating and defining a floating well node (fw);
a comparator circuit (230) comprising at least two second p-channel transistors (232, 234) with a threshold voltage (Vₜ) and their wells coupled to said floating well node (fw); and
an overstress circuit (203), the method comprising:
determining if the output circuit is tri-stated;
determining if a voltage applied to said IO PAD is greater than a first predetermined voltage level (VDDO+Vₜ) by the comparator circuit (230);
enabling the output circuit when the voltage applied to said IO PAD is greater than the first predetermined voltage level (VDDO+Vₜ);
in case the voltage at the floating well node (fw) is greater than a second predetermined voltage level (VDDO) pulling the gate terminal of one of the at least two second p-channel transistors (232, 234) to a third predetermined voltage level (VDDO-Vₜ) by at least one transistor device of the overstress circuit (203) to prevent overstress of the integrated circuit (200); and
turning on the stress circuit (217) for dissipating a voltage across the output circuit, thereby preventing the output circuit from experiencing hot carrier injection stress.

## Patentansprüche

1. Integrierte Schaltung (200), die umfasst:
- ein IO-PAD,
- eine Ausgangsschaltung, die wenigstens mit dem IO-PAD gekoppelt ist,
- eine Belastungsschaltung (217), die wenigstens mit der Ausgangsschaltung gekoppelt ist und wenigstens einen ersten p-Kanaltransistor (222) umfasst, dessen Wanne schwebend ist und einen schwebenden Wannenknoten (fw) definiert,
- eine Einrichtung zum Bestimmen, ob die Ausgangsschaltung für drei Zustände ausgelegt ist,
- eine Einrichtung (230) zum Bestimmen, ob eine an das IO-PAD angelegte Spannung größer ist als ein erster vorgegebener Spannungspegel (VDDO+Vₜ) und die wenigstens zwei zweite p-Kanaltransistoren (232, 234) umfasst, die eine Schwellenspannung (Vₜ) aufweisen und deren Wannen mit dem schwebenden Wannenknoten (fw) gekoppelt sind,
- eine Überbelastungsschaltung (203), die dafür ausgelegt ist, eine Überbelastung der integrierten Schaltung (200) zu verhindern, wenn die Spannung am schwebenden Wannenknoten (fw) größer ist als ein zweiter vorgegebener Spannungspegel (VDDO), indem der Gate-Anschluss eines der wenigstens zwei zweiten p-Kanaltransistoren (232, 234) mittels wenigstens einer Transistoreinrichtung auf einen dritten vorgegebenen Spannungspegel (VDDO-Vₜ) gezogen wird,
- eine Einrichtung zum Aktivieren der Ausgangsschaltung, wenn die an das IO-PAD angelegte Spannung größer ist als der erste vorgegebene Spannungspegel (VDDO+Vₜ), und
- eine Einrichtung zum Einschalten der Belastungsschaltung (217), um eine Spannung über der Ausgangsschaltung abzubauen, wodurch das Fortbestehen einer hohen Spannung über der Ausgangsschaltung begrenzt wird.

2. Integrierte Schaltung nach Anspruch 1, wobei die Belastungsschaltung (217) wenigstens einen weiteren Transistor umfasst.

3. Integrierte Schaltung nach Anspruch 2, wobei der Transistor wenigstens einen weiteren p-Kanaltransistor (220) umfasst.

4. Integrierte Schaltung nach Anspruch 2, wobei der Transistor zwei übereinander angeordnete p-Kanaltransistoren (222, 220) umfasst.

5. Integrierte Schaltung nach Anspruch 1, wobei die Ausgangsschaltung wenigstens einen Transistor umfasst.

6. Integrierte Schaltung nach Anspruch 5, wobei der Transistor einen n-Kanaltransistor (226) umfasst.

7. Integrierte Schaltung nach Anspruch 5, wobei der Transistor zwei übereinander angeordnete n-Kanaltransistoren (226, 224) umfasst.

8. Verfahren zum Verringern einer Belastung über einer Ausgangsschaltung einer integrierten Schaltung (200), die umfasst:
- ein IO-PAD,
- wobei die Ausgangsschaltung wenigstens mit dem IO-PAD gekoppelt ist,
- eine Belastungsschaltung (217), die wenigstens mit der Ausgangsschaltung gekoppelt ist und wenigstens einen ersten p-Kanaltransistor (222) umfasst, dessen Wanne schwebend ist und einen schwebenden Wannenknoten (fw) definiert,
- eine Vergleicherschaltung (230), die wenigstens zwei zweite p-Kanaltransistoren (232, 234) umfasst, die eine Schwellenspannung (Vₜ) aufweisen und deren Wannen mit dem schwebenden Wannenknoten (fw) gekoppelt sind, und
- eine Überbelastungsschaltung (203), wobei das Verfahren umfasst:
- Bestimmen, ob die Ausgangsschaltung für drei Zustände ausgelegt ist,
- Bestimmen, durch die Vergleicherschaltung (230), ob eine an das IO-PAD angelegte Spannung größer ist als ein erster vorgegebener Spannungspegel (VDDO+Vₜ),
- Aktivieren der Ausgangsschaltung, wenn die an das IO-PAD angelegte Spannung größer ist als der erste vorgegebene Spannungspegel (VDDO+Vₜ),
- wenn die Spannung am schwebenden Wannenknoten (fw) größer ist als ein zweiter vorgegebener Spannungspegel (VDDO), Ziehen des Gate-Anschlusses eines der wenigstens zwei zweiten p-Kanaltransistoren (232, 234) auf einen dritten vorgegebenen Spannungspegel (VDDO-Vₜ) mittels wenigstens einer Transistoreinrichtung der Überbelastungsschaltung (203), um eine Überbelastung der integrierten Schaltung (200) zu verhindern, und
- Einschalten der Belastungsschaltung (217), um eine Spannung über der Ausgangsschaltung abzubauen, wodurch verhindert wird, dass die Ausgangsschaltung einer Hot-Carrier-Injection-Belastung ausgesetzt wird.

## Revendications

1. Circuit intégré (200) comprenant :
une plage I/O ;
un circuit de sortie couplé à au moins ladite plage I/O ;
un circuit (217) de contrainte couplé à au moins ledit circuit de sortie et comprenant au moins un premier transistor (222) à canal p avec son puits flottant et définissant un noeud à puits flottant (fw) ;
un moyen pour déterminer si le circuit de sortie est à trois états ;
un moyen (230) pour déterminer si une tension appliquée à ladite plage I/O est supérieure à un premier niveau de tension prédéterminé (VDDO+Vₜ) et comprenant au moins deux deuxièmes transistors (232, 234) à canal p avec une tension de seuil (Vₜ) et leurs puits couplés audit noeud à puits flottant (fw) ;
un circuit (203) de surcontrainte adapté à prévenir une surcontrainte du circuit intégré (200) lorsque la tension au noeud à puits flottant (fw) est supérieure à un deuxième niveau de tension prédéterminé (VDDO) en tirant la borne de grille d'un des au moins deux deuxièmes transistors (232, 234) à canal p jusqu'à un troisième niveau de tension prédéterminé (VDDO-Vₜ) par au moins un dispositif à transistors ;
un moyen pour activer le circuit de sortie lorsque la tension appliquée à ladite plage I/O est supérieure au premier niveau de tension prédéterminé (VDDO+Vₜ); et
un moyen pour activer le circuit (217) de contrainte pour dissiper une tension dans le circuit de sortie, limitant ainsi une durée d'une haute tension dans le circuit de sortie.

2. Circuit intégré selon la revendication 1, dans lequel ledit circuit (217) de contrainte comprend au moins un autre transistor.

3. Circuit intégré selon la revendication 2, dans lequel ledit transistor comprend au moins un autre transistor (220) à canal p.

4. Circuit intégré selon la revendication 2, dans lequel ledit transistor comprend deux transistors (222, 220) à canal p empilés.

5. Circuit intégré selon la revendication 1, dans lequel ledit circuit de sortie comprend au moins un transistor.

6. Circuit intégré selon la revendication 5, dans lequel ledit transistor comprend un transistor (226) à canal n.

7. Circuit intégré selon la revendication 5, dans lequel ledit transistor comprend deux transistors (226, 224) à canal n empilés.

8. Procédé de réduction d'une contrainte dans un circuit de sortie d'un circuit intégré (200), comprenant :
une plage I/O ;
dans lequel le circuit de sortie est couplé à au moins ladite plage I/O ;
un circuit (217) de contrainte couplé à au moins ledit circuit de sortie et comprenant au moins un premier transistor (222) à canal p avec son puits flottant et définissant un noeud à puits flottant (fw) ;
un circuit (230) comparateur comprenant au moins deux deuxièmes transistors (232, 234) à canal p avec une tension de seuil (Vₜ) et leurs puits couplés audit noeud à puits flottant (fw) ; et
un circuit (203) de surcontrainte, le procédé comprenant :
la détermination si le circuit de sortie est à trois états ;
la détermination si une tension appliquée à ladite plage I/O est supérieure à un premier niveau de tension prédéterminé (VDDO+Vₜ) par le circuit (230) comparateur ;
l'activation du circuit de sortie lorsque la tension appliquée à ladite plage I/O est supérieure au premier niveau de tension prédéterminé (VDDO+Vₜ) ;
dans le cas où la tension au noeud à puits flottant (fw) est supérieure à un deuxième niveau de tension prédéterminé (VDDO), la traction de la borne de grille d'un des au moins deux deuxièmes transistors (232, 234) à canal p jusqu'à un troisième niveau de tension prédéterminé (VDDO-Vₜ) par au moins un dispositif à transistors du circuit (203) de surcontrainte pour prévenir une surcontrainte du circuit intégré (200) ; et
l'activation du circuit (217) de contrainte pour dissiper une tension dans le circuit de sortie, empêchant ainsi que le circuit de sortie ne connaisse une contrainte par injection de porteurs chauds.
